Europäisches Patentamt

European Patent Office

Office européen des brevets

(19)

(11) Numéro de publication : **0 423 666 B1**

(12) **FASCICULE DE BREVET EUROPEEN**

(45) Date de publication du fascicule du brevet :
**22.02.95 Bulletin 95/08**

(51) Int. Cl.⁶ : **H04L 27/36, H04B 1/62, H03F 1/32**

(21) Numéro de dépôt : **90119680.8**

(22) Date de dépôt : **15.10.90**

(54) **Procédé de correction numérique de non-linéarité d'une chaîne d'émission, et dispositif de mise en oeuvre de ce procédé.**

(30) Priorité : **18.10.89 FR 8913604**

(43) Date de publication de la demande :
**24.04.91 Bulletin 91/17**

(45) Mention de la délivrance du brevet :
**22.02.95 Bulletin 95/08**

(84) Etats contractants désignés :
**BE DE ES FR GB IT NL SE**

(56) Documents cités :
**US-A- 4 462 001**
**ICC '80 - INTERNATIONAL CONFERENCE ON COMMUNICATIONS, Seattle, US, 8-12 juin 1980,vol. 2, IEEE, New York, US;pages 158 - 162; R.P. HECKEN et al.:"Predistortion Linearization of the AR 6A Transmitter"**
**GLOBECOM '85 - IEEE GLOBAL TELECOMMUNICATIONS CONFERENCE, New Orleans, US, 2-5 décembre 1985, vol. 3, IEEE, New York, US;pages 1466 - 1470; T. NOJIMA et al.:"The Design of a Predistortion Linearization Circuit for High-Level Modulation Radio Systems"**

(73) Titulaire : **ALCATEL TELSPACE**
**5, rue Noel Pons**
**F-92734 Nanterre Cédex (FR)**
(84) **DE ES FR GB IT NL SE**
Titulaire : **ALCATEL N.V.**
**Strawinskylaan 341,**
**(World Trade Center)**
**NL-1077 XX Amsterdam (NL)**
(84) **BE**

(72) Inventeur : **Ravoalavoson, Robert**
**3, rue de la Sablière**
**F-92400 Courbevoie (FR)**
Inventeur : **Allemand, Guy**
**45, rue du Président Wilson**
**F-92300 Levallois Perret (FR)**

(74) Mandataire : **Weinmiller, Jürgen et al**
**Lennéstrasse 9**
**Postfach 24**
**D-82336 Feldafing (DE)**

EP 0 423 666 B1

## Description

L'invention concerne un procédé de correction numérique de non linéarité d'une chaîne d'émission, et un dispositif de mise en oeuvre de ce procédé.

Ledit procédé permet de compenser les effets des non linéarités, dues par exemple aux amplificateurs de puissance de la chaîne émission. Il s'applique en particulier aux modulations de type QAM ou "Quadrature Amplitude Modulation" (16, 64 et 256 QAM).

Le domaine d'application de l'invention est celui des transmissions hertziennes numériques point à point de grandes capacités. Ce type de transmission utilise des amplificateurs à TOP (Tubes à ondes progressives) ou à état solide (transistor FET ASGA par exemple).

Les modulations utilisées pour ce type de transmission (16 QAM, 64 QAM.) exigent une excellente linéarité de leurs chaînes de transmission, classiquement obtenue par une décote importante de l'amplificateur.

Par exemple pour un amplificateur à état solide on a :

* une décote de 6 à 7dB pour une modulation 16 QAM,
* une décote de 8 à 10 dB pour une modulation 64 QAM.

Par suite le rendement de l'amplificateur de puissance est particulièrement mauvais. On a par exemple :

* En 16 QAM : Puissance consommée = 40w
  Puissance de sortie = 5w
* En 64 QAM : Puissance consommée = 90w
  Puissance de sortie = 10w

Le brevet américain n°4.462.001 décrit un procédé de correction numérique de non linéarités d'une chaîne d'émission dans lequel les effets des non linéarités des amplificateurs sont compensés à l'aide d'une prédistorsion en bande de base avant modulation, le traitement numérique du signal ayant lieu en temps réel.

L'inconvénient de ce procédé est qu'il nécessite l'utilisation de tables de conversion de données puisqu'il fonctionne à partir de coordonnées polaires.

L'invention a pour objet de pallier ces différents inconvénients.

Elle propose, à cet effet, un procédé de correction numérique de non linéarités d'une chaîne d'émission, dans lequel on compense les effets des non linéarités des amplificateurs à l'aide d'une prédistorsion en bande de base avant modulation, le traitement numérique du signal ayant lieu en temps réel, caractérisé en ce que le traitement numérique a lieu en coordonnées cartésiennes en définissant deux nouveaux axes attachés au vecteur à corriger ; le premier étant colinéaire audit vecteur, le second en quadrature avec celui-ci.

Les caractéristiques et avantages de l'invention ressortiront d'ailleurs de la description qui va suivre, à titre d'exemple non limitatif, en référence aux figures annexées sur lesquelles :

- Les figures 1 et 2 illustrent le domaine de l'invention ;
- les figures 3 à 5 illustrent différentes réalisations de l'art antérieur ;
- les figures 6 à 9 illustrent le procédé et le dispositif de l'invention.

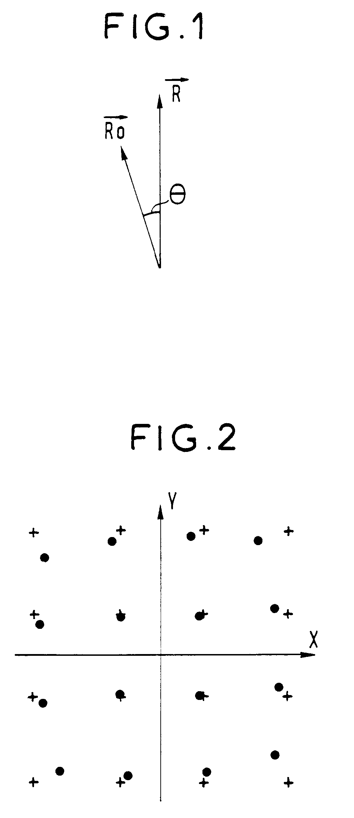

Les figures 1 et 2 illustrent l'utilité d'un système de prédistorsion à l'émission.

A la figure 1, est représenté un diagramme de FRESNEL du signal émis à un instant donné, en présence de distorsion ; on a, ainsi :

- un vecteur R qui est le vecteur attendu,
- un vecteur Ro qui est le vecteur effectivement émis.

Il y a déformation de l'amplitude et de la phase initiale du vecteur attendu.

Le diagramme, représenté à la figure 2, montre l'exemple d'une constellation de type 16 QAM distordue, avec :

"+" : points désirés
"." : points effectivement émis.

Le problème de correction de la saturation des amplificateurs à l'émission est bien connu et a déjà fait l'objet de quelques applications dans les domaines analogique et digital.

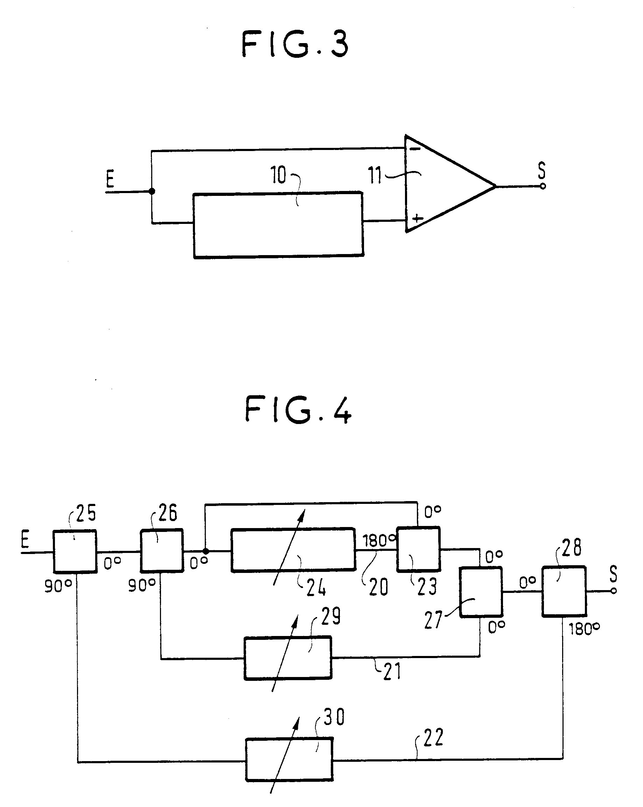

L'élément de base d'un correcteur analogique est un expandeur élaboré autour d'un élément non linéaire 10. Son principe général est résumé par le synoptique représenté sur la figure 3, entre une entrée E et une sortie S : Un amplificateur 11 reçoit sur une entrée le signal E et sur l'autre ce même signal E après passage dans l'élément non linéaire 10. La correction apportée par un tel élément 10 est pratiquement scalaire.

Cependant, certains systèmes à plusieurs voies permettent de prédistordre à la fois l'amplitude et la phase du signal avant amplification, en fréquence intermédiaire et en hyperfréquence.

Leur synoptique commun est représenté sur la figure 4. Dans ce synoptique à trois voies 20, 21 et 22, la première voie 20 comprend un coupleur 180° 23, dont les deux entrées sont reliées entre elles avec un élément non linéaire 24 disposé sur l'entrée 180°, recevant le signal d'entrée E après passage dans deux coupleurs déphaseurs 25 et 26 et étant relié à la sortie S au travers de deux coupleurs 0° 27 et 28. La seconde voie 21 comporte un atténuateur 29 disposé entre le second coupleur déphaseur 90° 26 et le premier coupleur 0° 27. La troisième voie 22 comporte un déphaseur 90° 30 disposé entre le premier coupleur déphaseur 90° 25 et le second coupleur déphaseur 180° 28.

La première voie 20 crée un vecteur prédistordu, dont la sommation avec la seconde voie 21 constitue la correction en module.

La sommation de la troisième voie 22, de déphasage ajustable, permet d'optimiser la prédistorsion en phase.

En fréquence intermédiaire, les inconvénients sont :

- une limitation en bande passante, due au rapport bande passante de correction/fréquence de travail notamment au niveau du coupleur déphaseur à l'entrée,
- une interdépendance entre les paramètres module et phase, qui ne permet pas une correction efficace de la phase.

En hyperfréquence, on n'est pas gêné par les bandes passantes des différents coupleurs, par contre les inconvénients spécifiques sont :

- un prix de revient élevé des composants,
- des ajustements nombreux et de convergence délicate, ce qui interdit la possibilité d'un asservissement.

Il est possible aussi d'envisager une correction numérique. Les systèmes de prédistorsion utilisant ce principe opèrent en bande de base.

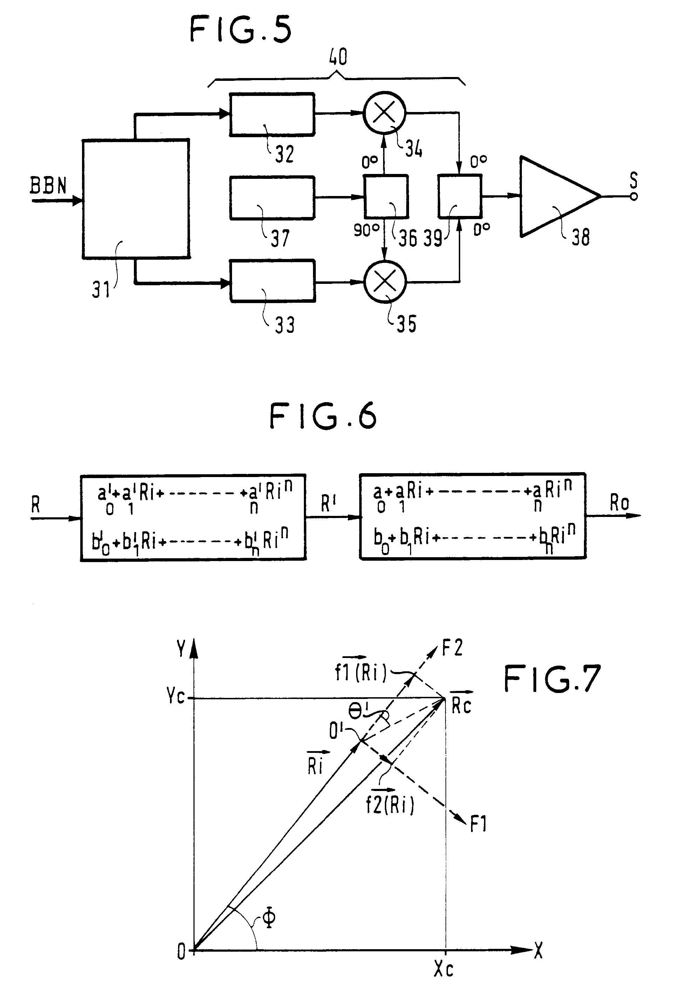

Les synoptiques existant ont la structure schématique représentée à la figure 5. La bande de base numérique BBN est traitée par une table de conversion 31, laquelle transmet les échantillons-résultats à deux convertisseurs numérique/analogique 32 et 33. Les sorties de ces deux convertisseurs 32 et 33 sont reliées respectivement à deux mélangeurs 34 et 35 reliés eux-mêmes aux deux sorties d'un coupleur 0°-90° 36 qui reçoit l'oscillateur local 37. Les sorties des deux mélangeurs 34 et 35 sont reliées à l'amplificateur 38, source des distorsions, au travers d'un coupleur 0° 39. La partie référencée 40 correspond à la modulation du signal.

Le principe d'une correction numérique en utilisant une table est décrit dans l'article de A.M. SALEH dans le "Bell system technical journal" du 29 avril 1982 intitulé "Matrix analysis of mildy nonlinear, multiple-input, multiple-output systems with memory": ce principe est celui d'une table de valeurs chargée dans une mémoire vive ("RAM") et adressée à partir des données.

De même que dans les systèmes précédents, dans le synoptique représenté à la figure 5, il faut deux voies modulant les deux phases en quadrature d'un même oscillateur.

La table de conversion tient compte, suivant les systèmes rencontrés, soit de l'amplitude seule, soit de la phase seule, soit des deux. Le système est entièrement défini par sa table de conversion, et peut donc entièrement compenser la courbe de saturation d'un amplificateur aussi bien en amplitude qu'en phase.

Mais ses inconvénients sont :

- le principe de la table de conversion, qui rend le système spécifique d'une saturation donnée,
- la définition, par la table d'une fonction fixe. On ne suit aucunement les phénomènes de dérive thermique et de vieillissement des composants, sauf peut être en commutant sur une autre table : dans ce cas, on double le volume de mémoire nécessaire, et l'asservissement est très difficile et très lent, car on doit modifier entièrement le contenu de la table.

Par ailleurs, une perte de contenu mémoire suite à un parasitage d'alimentation est sans remède rapide, ce qui nuit à la disponibilité du système.

Enfin, le calcul matriciel que l'on doit effectuer est, outre sa lenteur consommateur lui aussi de place mémoire.

Par contre le procédé de l'invention fait appel à un traitement numérique de signal en temps réel. On fait ainsi disparaitre la notion de table de conversion. Ce traitement numérique est opéré sur le signal bande de base avant modulation.

Le signal d'entrée est échantillonné en respect du théorème de SHANNON, selon lequel, pour numériser des signaux, il est nécessaire que la fréquence d'échantillonnage soit supérieure ou égale à deux fois la fréquence maximum contenue dans la Bande Passante utile du signal, et peut être filtré numériquement (l'échantillon est, dans ce dernier cas, défini sur un nombre de bits élevé).

On connait la forme générale des fonctions de saturation. Pour une amplitude $R_i$ à l'entrée d'un système non linéaire, la sortie, en un instant quelconque, est de la forme :

$$R_o = a_0 + a_1 R_i + a_2 R_i^2 + a_3 R_i^3 ... + a_n R_i^n$$

Il en est de même pour le déphasage de la sortie par rapport à l'entrée.

$$\theta = b_0 + b_1 R_i + b_2 R_i^2 + b_3 R_i^3 + ... b_n R_i^n$$

Il est donc possible d'opérer en amont de l'amplificateur, une correction en amplitude et en déphasage par deux autres polynômes :

$$R' = a'_0 + a'_1 R_i + a'_2 R_i^2 + a'_3 R_i^3 + ... + a'_n R_i^n$$

et

$$\theta' = -\theta = b'_0 + b'_1 R_i + b'_2 R_i^2 + b_3' R_i^3 + ... b'_n R_i^n$$

Le principe de cette correction est résumé dans le synoptique représenté à la figure 6.

En traitement numérique, les coefficients $a'_i$ et $b'_i$ du calcul polynômial peuvent être ajustés à volonté, par exemple à l'aide d'une boucle d'asservissement sur la sortie de l'émetteur.

Un vecteur quelconque est défini par ses coordonnées cartésiennes $X_i$ et $Y_i$ suivant les deux axes définis par la modulation.

Le diagramme vectoriel représenté à la figure 7 donne un exemple de la correction à effectuer : Si on appelle $R_i$, le module du vecteur à corriger, et $\phi$, sa phase par rapport à l'axe OX, on définit deux nouveaux axes attachés au vecteur, le premier $O'F_1$, colinéaire au vecteur, le second, $O'F_2$, en quadrature.

Suivant ces deux nouveaux axes, deux corrections, respectivement $f_1$ (Ri) et $f_2$ (Ri), sont à opérer :

$$f_1 \text{ (Ri)} = R' \cos \theta' \text{ et } f_2 \text{ (Ri)} = R' \sin \theta'$$

L'idée fondamentale de l'invention est de rester en coordonnées cartésiennes, (afin d'éviter le passage en coordonnées polaires, qui exigerait deux tables de conversion de coordonnées), et d'interpréter la signification des corrections sur ces deux axes.

La valeur, petite, des angles de déphasage rencontrés (ils n'excèdent pas 5 degrés au point à 1 dB de compression ; c'est-à-dire 1dB au dessous de la réponse amplitude/amplitude considérée comme parfaitement linéaire), permet une utilisation des développements polynômiaux de $\cos \theta'$ et de $\sin \theta'$.

$f_1$ (Ri) et $f_2$ (Ri) restent ainsi deux polynômes à coefficients fixes (mais modifiables).

Ramenées aux axes fixes OX et OY, les corrections deviennent :

$$Xc = Ri.\cos\phi \, \frac{f_1 \text{ (Ri)}}{R_c} + Ri.\sin\phi \, \frac{f_2 \text{ (Ri)}}{R_c} = X_i \frac{f_1 \text{ (Ri)}}{R_c}$$
$$+ Y_i \frac{.f_2 \text{ (Ri)}}{R_c}$$
$$Yc = Ri.\sin\phi \, \frac{f_1 \text{ (Ri)}}{R_c} - Ri.\cos\phi \, \frac{f_2 \text{ (Ri)}}{R_c} = Y_i \frac{.f_1 \text{ (Ri)}}{R_c}$$
$$- X_i \frac{.f_2 \text{ (Ri)}}{R_c}$$

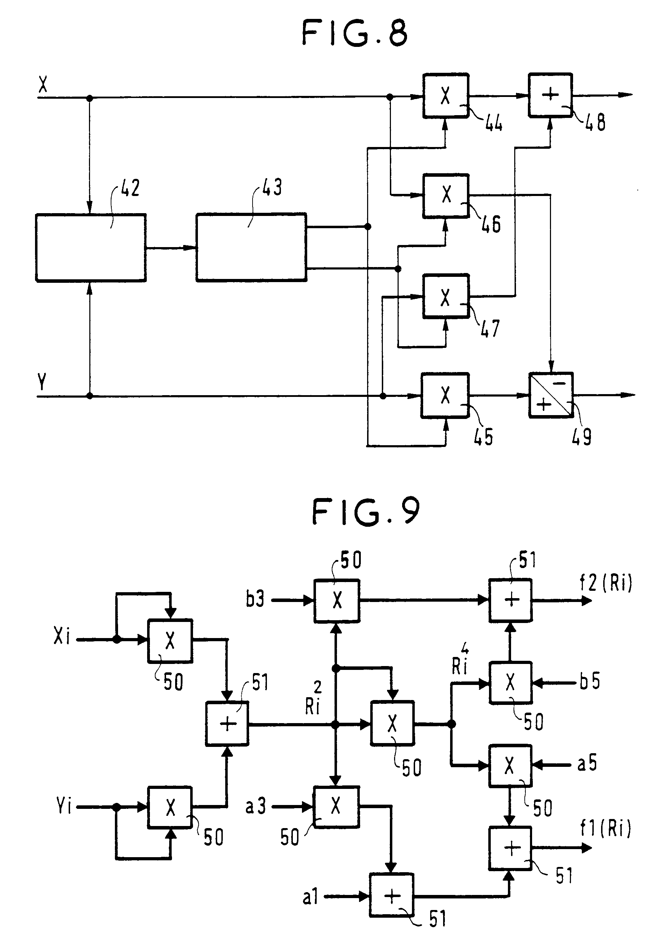

ce qui donne le synoptique de la figure 8.

Le terme Rc, constante homogène à une amplitude, exprime le fait que $\frac{f_1 \text{ (Ri)}}{R_c}$ et $\frac{f_2 \text{ (Ri)}}{R_c}$ sont sans dimension.

Ce synoptique comprend un circuit 42 de détermination du module Ri du vecteur à corriger, recevant les signaux X et Y avant modulation, suivi d'un circuit 43 de calcul de $f_1$ (Ri) et de $f_2$ (Ri) dont les deux sorties, correspondant à ces deux signaux, sont reliées chacune à une entrée de deux multiplieurs 44 et 45 (46 et 47) dont les secondes entrées 44 et 46 ; 45 et 47 reçoivent respectivement les signaux X et Y. Les sorties des deux multiplieurs 44 et 47 sont reliées aux entrées d'un sommateur 48 dont la sortie est connectée au convertisseur numérique-analogique voie X. Les sorties des deux multiplieurs 46 et 45 sont reliées aux entrées - et + d'un soustracteur 49 dont la sortie est connectée au convertisseur numérique-analogique voie Y.

La figure 9 donne un exemple de détermination de $f_1$ et de $f_2$ avec des temps de calcul supposés nuls, en utilisant des multiplieurs 50 et des additionneurs 51.

Les entrées Xi et Yi de ce dispositif sont les coordonnées du vecteur Ri qui sont des signaux numériques à plusieurs bits en parallèles par exemple 10 ; les constantes ai et bi étant modifiables de l'extérieur.

Le dispositif de l'invention présente de nombreux avantages :

- Le traitement en coordonnées cartésiennes évite la gestion de l'angle $\phi$ du vecteur à corriger.

- Puisqu'il n'y a pas de changement de système de coordonnées, on peut intervenir à tout moment de la correction pour un éventuel traitement complémentaire.

- L'élaboration de la correction n'étant pas sur les chemins des signaux, le système est facilement et rigoureusement neutralisable en annulant les coefficients des polynômes correcteurs, à l'exception du terme $a'1$ qui est égal à 1.

- Les coefficients des polynômes sont modifiables à volonté, donc en particulier peuvent être asservis pour suivre les phénomènes de dérive des caractéristiques.

- Enfin, on peut insérer directement le système derrière un filtre numérique, sans en altérer le fonctionnement.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1. Procédé de correction numérique de non linéarités d'une chaîne d'émission, dans lequel on compense les effets des non linéarités des amplificateurs à l'aide d'une prédistorsion en bande de base avant modulation, le traitement numérique du signal ayant lieu en temps réel, caractérisé en ce que le traitement numérique a lieu en coordonnées cartésiennes en définissant deux nouveaux axes attachés au vecteur à corriger ; le premier étant colinéaire audit vecteur, le second en quadrature avec celui-ci.

2. Procédé selon la revendication 1, caractérisé en ce qu'on opère, en amont de l'amplificateur (28), une correction en amplitude et en phase en utilisant deux polynômes relatifs à l'amplitude R', et au déphasage $\theta'$, soit :

$$R' = a'_0 + a'_1 Ri + ... a'_n Ri^n$$
$$\theta' = b'_0 + b'_1 Ri + ... b'_n Ri^n$$

avec une amplitude Ri en entrée, $a'_0$ à $a'_n$ étant des coefficients fixes et n entier.

3. Procédé selon la revendication 2, caractérisé en ce que ladite correction en amplitude et en phase deviennent, lorsque ramenées auxdits nouveaux axes :

$$Xc = X_i[f_1(Ri)/Rc] + Y_i[f_2(Ri)/Rc]$$
$$Yc = Y_i[f_1(Ri)/Rc] - X_i[f_2(Ri)/Rc],$$

avec Rc une amplitude, $X_i$ et $Y_i$ les coordonnées cartésienne dudit vecteur.

4. Procéde selon la revendication 2, caractérisé en ce que les coefficients du polynômes sont modifiables à volonté.

5. Dispositif de mise en oeuvre du procédé selon l'une quelconque des revendications précédentes, comprenant un circuit (42) de détermination du module du vecteur à corriger (Ri) recevant les signaux avant modulation (X et Y), caractérisé en ce que ce circuit (42) est suivi d'un circuit (43) de calcul de deux corrections ($f_1$(Ri), $f_2$ (Ri) à effectuer selon deux axes attachés audit vecteur dont les deux sorties sont reliées chacune à une première entrée de deux multiplieurs (44, 45 ; 46, 47) dont les secondes entrées (44 et 46 ; 45 et 47) reçoivent respectivement lesdits signaux avant modulation (X et Y) ; les sorties de deux multiplieurs (44 et 47) étant reliées aux entrées d'un sommateur (48) dont la sortie est connectée au convertisseur numérique-analogique voie X, les sorties de deux autres multiplieurs (45 et 46) étant reliées aux entrées d'un soustracteur (49) dont la sortie est connectée au convertisseur numérique-analogique voie Y.

**Patentansprüche**

1. Verfahren zum digitalen Korrigieren von Nichtlinearitäten einer Sendekette vor, bei dem man die Wirkungen der Nichtlinearitäten der Verstärker mit Hilfe einer Vorverzerrung im Basisband vor der Modulation kompensiert, wobei die digitale Behandlung des Signals in Echtzeit erfolgt, dadurch gekennzeichnet, daß die digitale Behandlung in kartesischen Koordinaten stattfindet, indem zwei neue Achsen definiert werden, die an den zu korrigierenden Vektor angesetzt werden, wobei die erste Achse kolinear zum Vektor verläuft und die zweite in Quadratur zu diesem verläuft.

2. Verfahren nach Anspruch 1, dadurch gekennzeichnet, daß man vor dem Verstärker (28) eine Amplituden- und Phasenkorrektur unter Verwendung zweier sich auf die Amplitude R' und die Phasenverschiebung $\theta'$ beziehender Polynome durchführt, nämlich:
$$R' = a'_0 + a'_1 Ri + ... a'_n Ri^n$$
$$\theta' = b'_0 + b'_1 Ri + ... b'_n Ri^n$$
wobei Ri die Eingangsamplitude, $a'_0$ bis $a'_n$ feste Koeffizienten und n eine ganze Zahl sind.

3. Verfahren nach Anspruch 2, dadurch gekennzeichnet, daß die Korrektur nach Amplitude und Phase, wenn diese auf die neuen Achsen bezogen sind, folgende Form annimmt:
$$Xc = X_i[f_1(Ri)/Rc] + Y_i [f_2(Ri)/Rc]$$

$$Yc = Y_i[f_1(Ri)/Rc] - X_i [f_2(Ri)/Rc]$$
wobei Rc eine Amplitude und Xi und Yi die kartesischen Koordinaten des Vektors sind.

4. Verfahren nach Anspruch 2, dadurch gekennzeichnet, daß die Koeffizienten der Polynome nach Wunsch modifizierbar sind.

5. Vorrichtung zur Durchführung des Verfahrens nach einem beliebigen der vorhergehenden Ansprüche, wobei die Vorrichtung eine Schaltung (42) zur Bestimmung des Moduls des zu korrigierenden Vektors (Ri) aufweist, die die Signale vor der Modulation (X und Y) empfängt, dadurch gekennzeichnet, daß auf diese Schaltung (42) eine Schaltung (43) zur Berechnung von zwei Korrekturen ($f_1$(Ri), $f_2$(Ri)) folgt, die gemäß zweier an den genannten Vektor angesetzten Achsen durchzuführen sind, wobei die beiden Ausgänge dieser Schaltung je an einen ersten Eingang zweier Multiplizierer (44, 45; 46, 47) angeschlossen sind, deren zweite Eingänge (44 und 46; 45 und 47) die genannten Signale (X bzw. Y) vor der Modulation empfangen, und wobei die Ausgänge von zwei Multiplizierern (44 und 47) mit den Eingängen eines Summierers (48) verbunden sind, dessen Ausgang an den D/A-Wandler des Kanals X angeschlossen ist, während die Ausgänge der beiden anderen Multiplizierer (45 und 46) mit den Eingängen eines Subtrahierers (49) verbunden sind, dessen Ausgang an den D/A-Wandler des Kanals Y angeschlossen ist.

**Claims**

1. A digital method of correcting non-linearities in a transmission chain, in which the effects of amplifier non-linearities are compensated by means of baseband predistortion prior to modulation, the digital processing of the signal taking place in real time, the method being characterized in that the digital processing is applied to Cartesian coordinates defining two new axes attached to the vector to be corrected, the first new axis being colinear therewith, and the second being in quadrature therewith.

2. A method according to claim 1, characterized in that amplitude and phase correction are performed upstream of an amplifier (28) by using two polynomials relating to the amplitude R' and the phase shift $\theta'$ to be applied, where:
$$R' = a'_0 + a'_1 Ri + ... a'_n Ri^n$$
$$\theta' = b'_0 + b'_1 Ri + ... b'_n Ri^n$$
with Ri being the input amplitude, $a'_0$, a' and $a'_n$ being fixed coefficients, and n being an integer.

3. A method according to claim 2, characterized in that, when reduced to said nex axes, said amplitude correction and said phase correction become:

$$Xc = X_i[f_1(Ri)/Rc] + Y_i[f_2(Ri)/Rc]$$
$$Yc = Y_i[f_1(Ri)/Rc] - X_i[f_2(Ri)/Rc]$$

with Rc being the amplitude, and $X_i$ and $Y_i$ the Cartesian coordinates of said vector.

4. A method according to claim 2, characterized in that the coefficient of the polynomials are modifiable at will.

5. Apparatus for implementing the method according to any preceding claim, the apparatus comprising a circuit (42) for determining the modulus (Ri) of the vector to be corrected, said circuit receiving X and Y signals prior to modulation, the apparatus being characterized in that the circuit (42) is followed by a circuit (43) for calculating two corrections ($f_1(Ri)$, $f_2(Ri)$) to be applied along two axes determined relative to said vector, said circuit having two outputs each connected to a first input of two corresponding multipliers (44, 45; 46, 47) with the second inputs of the multipliers (44 & 46; 45 & 47) respectively receiving said X and Y signals prior to modulation; the outputs from two of the multipliers (44 and 47) being connected to the inputs of a summing circuit whose output is connected to a digital-to-analog converter for the X path, and the output from the other two multipliers (45 and 46) being connected to the input of a subtractor (49) whose output is connected to a digital-to-analog converter for the Y path.

# FIG.1

# FIG.2

# FIG.3

# FIG.4

# FIG.5

40

BBN

31

32

33

37

34

35

36  39

0°

0°

90°

0°

0°

38

S

# FIG.6

R

$$a_0^I + a_1^I Ri + \text{-----} + a_n^I Ri^n$$
$$b_0^I + b_1^I Ri + \text{-----} + b_n^I Ri^n$$

$R^I$

$$a_0 + a_1 Ri + \text{-----} + a_n Ri^n$$
$$b_0 + b_1 Ri + \text{-----} + b_n Ri^n$$

$Ro$

# FIG.7

$Y$

$Yc$

$\vec{F2}$

$\vec{f1(Ri)}$

$\vec{Rc}$

$\theta^I$

$0^I$

$\vec{Ri}$

$\vec{f2(Ri)}$

$F1$

$\Phi$

$0$

$Xc$

$X$

# FIG.8

# FIG.9